# EUROPEAN PATENT APPLICATION

(11) **EP 3 986 093 A1**
(43) Date of publication of application: **20.04.2022**
(21) Application number: 19932458.3
(22) Date of filing: 13.06.2019
(51) Int. Cl.: H05K 1/02, H05K 3/00, H05K 3/46

(54) **MULTILAYER CIRCUIT SUBSTRATE AND METHOD FOR MANUFACTURING THE SAME**

(71) Applicant: FUJI Corporation, Chiryu, Aichi 472-8686 (JP)
(72) Inventor: TAKEUCHI, Tasuku, Chiryu-shi, Aichi 472-8686 (JP); TOMINAGA, Ryojiro, Chiryu-shi, Aichi 472-8686 (JP)
(74) Representative: Grünecker Patent- und Rechtsanwälte PartG mbB
(86) International application number: PCT/JP2019/023489
(87) International publication number: WO 2020/250381

(57) **Abstract**

In multilayer circuit substrate (11) in which multiple insulating layers (12a and 12b) are stacked, wiring patterns (13a and 13b) and reference marks (14a and 14b) are formed on an upper surface of each insulating layer in a predetermined positional relationship, and the reference marks on the insulating layers are formed at overlapping positions when viewed from above. Furthermore, the reference mark on each layer is formed by changing a size or a shape such that from a specific edge portion recognized when center coordinates of the reference mark is detected by image processing a specific edge portion of the reference mark on a lower layer of the specific edge portion does not protrude considering a positional deviation at the time of manufacturing. The multiple insulating layers are formed of an insulating material having light transparency or an insulating material designed to be extremely thin so that a lower layer can be seen through even if the light transparency is poor.

## Description

### Technical Field

The present specification discloses a technology relating to a multilayer circuit substrate in which multiple insulating layers are stacked and wiring patterns and reference marks are formed on an upper surface of each insulating layer in a predetermined positional relationship, and a method for manufacturing the same.

### Background Art

In the conventional art, there are various methods for manufacturing a multilayer circuit substrate, and for example, a method in which multiple insulating layers are stacked after forming a wiring pattern on an upper surface of the non-stacked multiple insulating layers, a method of manufacturing a multilayer circuit substrate by repeating steps of forming an upper insulating layer with an insulating material on a lower insulating layer on which the wiring pattern is formed, and forming a wiring pattern on an upper surface of the upper insulating layer, or the like are known. Since the wiring pattern on each layer of the multilayer circuit substrate is structured to be interlayer-connected to each other through a via hoe or the like, when an amount of positional deviation of the wiring patterns between the layers becomes large, it will cause a connection failure between the layers and deterioration of connection reliability.

Therefore, as described in Patent Literature 1 (JP-A-2018-1723), a technology is disclosed, in which, when forming a reference mark on each layer and stacking an upper layer on a lower layer, a position of the reference mark on the lower layer is recognized by imaging the reference mark on the lower layer from above with a camera and processing the image, the upper layer is positioned with reference to the position of the reference mark on the lower layer, and stacked on the lower layer, and then, the amount of positional deviation between the layers is reduced.

In this case, since the reference mark on each layer is formed in a space having a narrow margin outside the wiring pattern forming area on each layer, the reference marks on each layer are generally formed at an overlapping position when viewed from above. In addition, the position of the reference mark is expressed by center coordinates of the reference mark, a specific edge portion of the reference mark (for example, an outside edge portion or the like) is image-recognized from above during stacking, and the center coordinates of the reference mark is calculated from the position of the specific edge portion.

### Patent Literature

Patent Literature 1: JP-A-2018-1723

### Summary of the Invention

### Technical Problem

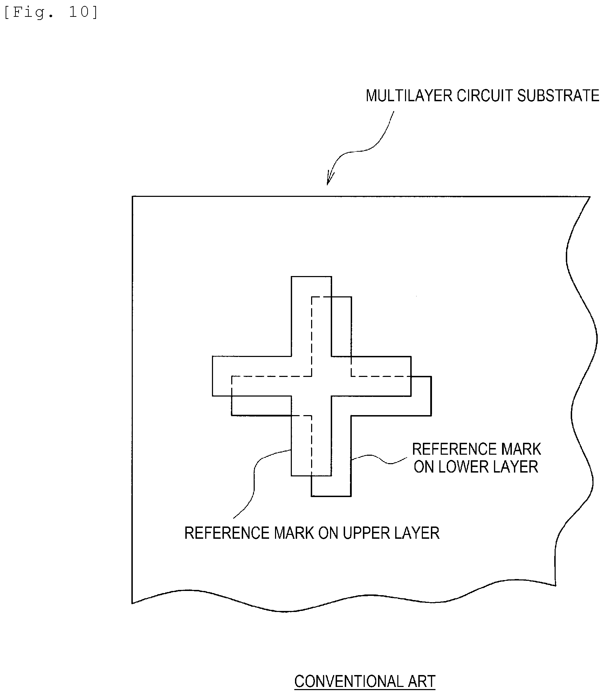

In response to the recent demand for thinning the multilayer circuit substrates, since the insulating layer of each layer is thinned to the maximum extent, the reference mark or the wiring pattern of the lower layer may be seen through when stacking. In particular, in a multilayer circuit substrate in which the insulating layer of each layer is formed of an insulating material having light transparency, the reference mark and the wiring pattern on the lower layer can be seen through more clearly. Therefore, even when the reference marks having the same shape are designed to be formed at the same positions on each layer, the reference mark on the upper layer is image-recognized without completely overlapping with the reference mark on the lower layer by the positional deviation due to the manufacturing tolerance, but as illustrated in Fig. 10, the reference mark on each layer is image-recognized with a positional deviation as much as the amount of positional deviation at the time of manufacturing. In this image recognition, it is difficult to distinguish the reference mark on the lower layer that can be seen through from the reference mark on the upper layer, a shape of the image-recognized reference mark is recognized as a shape of one reference mark that includes the protruding part of the reference mark on the lower layer that protrudes from the reference mark on the upper layer due to the positional deviation, the center coordinates of the reference mark will be detected based on the position of a specific edge portion of the shape. Therefore, the detection accuracy of the center coordinates of the reference marks on the upper layer by the image processing deteriorates due to the positional deviation of the reference marks on each layer at the time of manufacturing. The deterioration in the detection accuracy of the center coordinates of the reference mark causes the increase of the amount of positional deviation of the wiring patterns between the layers of the multilayer circuit substrate to be manufactured, and causes the deterioration of the connection reliability between the layers.

### Solution to Problem

In order to solve the problems described above, in a multilayer circuit substrate in which multiple insulating layers are stacked, wiring patterns and reference marks are formed on an upper surface of each insulating layer in a predetermined positional relationship, and the reference marks on the insulating layers are formed at an overlapping position when viewed from above, the reference mark on each layer is formed by changing a size or a shape such that from a specific edge portion recognized when center coordinates of the reference mark is detected by image processing a specific edge portion of the reference mark on a lower layer of the specific edge portion does not protrude considering a positional deviation at the time of manufacturing. In other words, the size or the shape of the reference marks on each layer is changed such that the specific edge portion of the reference marks on the upper layer covers and hides the specific edge portion of the reference marks on the lower layer.

In this configuration, since each reference mark is formed by changing the size or shape such that the specific edge portion of reference mark on the lower layer does not protrude from the specific edge portion recognized when the center coordinates of reference mark on the upper layer is detected by image processing considering the positional deviation of reference marks on each layer at the time of manufacturing, it is possible to prevent the specific edge portion of the reference mark on the lower layer from protruding from the specific edge of the reference mark on the upper layer which is image-recognized as an image from above during stacking. As a result, the specific edge portion of the reference mark on the upper layer can be accurately image-recognized, and the center coordinates of the reference mark on the upper layer can be accurately detected from the position of the specific edge portion, and thus, it is possible to improve the positioning accuracy of each layer of multilayer circuit substrate and improve the connection reliability between the layers.

### Brief Description of Drawings

Fig. 1 is a diagram illustrating a structure in which a first layer and a second layer of a multilayer circuit substrate in an embodiment are stacked.
Fig. 2 is a top view illustrating a first example in which a size of a reference mark on an upper layer is made larger than a size of a reference mark on a lower layer.
Fig. 3 is a vertical cross-sectional view taken along the line III-III of Fig. 2.
Fig. 4 is top view illustrating a second example in which the shape of the reference mark on the upper layer is changed so as to cover the entire reference mark on the lower layer.
Fig. 5 is a vertical cross-sectional view taken along the line IV-IV of Fig. 4.
Fig. 6 is a top view illustrating a third example in which the shape of the reference mark on the upper layer is changed so as to cover and hide an outer peripheral edge which is a specific edge portion of the reference mark on the lower layer.
Fig. 7 is a vertical cross-sectional view taken along the line VII-VII of Fig. 6.
Fig. 8 is a top view illustrating a fourth example in which the size of the reference mark on the upper layer is made smaller than the size of the reference mark on the lower layer.
Fig. 9 is a vertical cross-sectional view taken along the line IX-IX of Fig. 8.
Fig. 10 is a top view illustrating a positional deviation between the reference mark on the upper layer and the reference mark on the lower layer in the conventional art.

### Description of Embodiments

Hereinafter, embodiments disclosed in the present specification will be described.

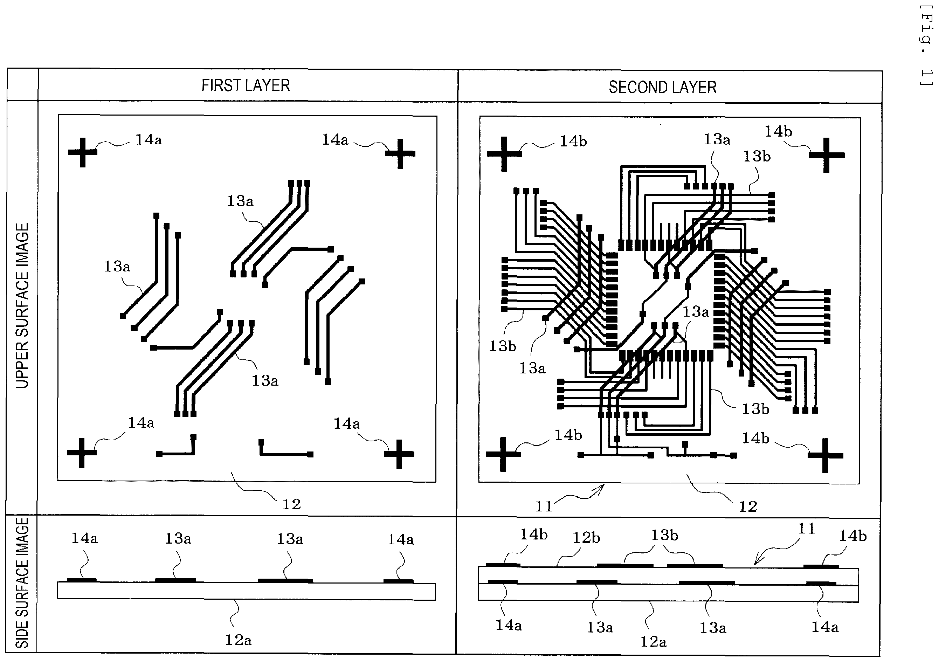

First, a configuration of multilayer circuit substrate 11 will be described based on Fig. 1. In multilayer circuit substrate 11, multiple insulating layers 12a and 12b are stacked, and wiring patterns 13a and 13b and reference marks 14a and 14b are formed in a predetermined positional relationship on an upper surface of insulating layers 12a and 12b of each layer. Insulating layers 12a and 12b of each layer are formed of an insulating material having light transparency or an insulating material designed to be extremely thin so that a lower layer can be seen through even if the light transparency is poor. As the insulating material, for example, acrylic resin, epoxy resin, polyimide resin, glass or the like may be used. The insulating layers 12a and 12b of each layer may be stacked by molding the insulating material in a sheet shape (a film shape), or may be formed by a three-dimensionally stacked modeling in such a manner that ink of the insulating material is discharged using a 3D printer to form first insulating layer 12a, and insulating layer 12b of the next layer is accumulated on insulating layer 12a in order.

Reference marks 14a and 14b on each layer are formed on an overlapping position when viewed from above (the same position) in a margin space outside the forming area of wiring patterns 13a and 13b (for example, four corners or four sides of insulating layers 12a and 12b of each layer), and are designed such that the center coordinates of reference marks 14a and 14b on each layer coincide with each other if there is no positional deviation at the time of manufacturing. The shapes of reference marks 14a and 14b are, for example, a cross shape, a circle shape, a square shape, a ring shape, and the like, and a main point thereof may be a shape in which the center coordinates is uniquely determined from the position of a specific edge portion described later. The number of reference marks 14a and 14b on each layer is not limited to four, and may be two or more.

Wiring patterns 13a and 13b and reference marks 14a and 14b on each layer are simultaneously formed on the upper surface of insulating layers 12a and 12b of each layer using the same conductive material by the wiring pattern forming technology in order to maintain a constant positional relationship between them. The wiring pattern forming technology for forming wiring patterns 13a and 13b and reference marks 14a and 14b may be any one of, for example, a printed wiring technology (etching method, plating method), a thick film pattern forming method (screen printing method, drawing method, and the like), and a thin film pattern forming methods (CVD method, PVD method, and the like). When modeling multilayer circuit substrate 11 using a 3D printer, each time modeling insulating layers 12a and 12b on each layer, ink of metal nanoparticles which are conductive materials may be discharged onto the upper surface of insulating layers 12a and 12b, and wiring patterns 13a and 13b and reference marks 14a and 14b on each layer may be printed at the same time.

As described before, since wiring patterns 13a and 13b on each layer is structured to be interlayer-connected to each other through a via hole or the like, when an amount of positional deviation of the wiring patterns 13a and 13b between the layers becomes large, it will cause a connection failure between the layers and deterioration of connection reliability. Therefore, when stacking the upper layer on the lower layer, a position of reference mark 14a on the lower layer is recognized by imaging reference mark 14a on the lower layer from above with a camera and processing the image, the upper layer is positioned with reference to the position of the reference mark 14a on the lower layer, and stacked on the lower layer, and then, the amount of positional deviation between the layers is reduced. At this time, the position of reference marks 14a and 14b are expressed by center coordinates of reference marks 14a and 14b, a specific edge portion of reference marks 14a and 14b (for example, outside edge portion or the like) are image-recognized from above during stacking, and the center coordinates of reference mark 14a and 14b are calculated from the position of the specific edge portion.

However, since reference marks 14a and 14b on each layer deviate by the amount of positional deviation at the time of manufacturing, as with conventional art, when the reference marks are designed to be formed on same position on each layer in the same shape, the shape of the image-recognized reference mark is recognized as a shape of one reference mark that includes the protruding part of the reference mark on the lower layer that protrudes from the reference mark on the upper layer due to the positional deviation, the center coordinates of the reference mark will be detected based on the position of a specific edge portion of the shape. Therefore, the detection accuracy of the center coordinates of the reference marks on the upper layer by the image processing deteriorates due to the positional deviation of the reference marks on each layer at the time of manufacturing, and accordingly, the amount of positional deviation of the wiring patterns between the layers of the multilayer circuit substrate to be manufactured is increased, and thus, the connection reliability between the layers is deteriorated.

As a countermeasure against this problem, in the present embodiment, reference marks 14a and 14b on each layer are formed by changing the size or shape considering the positional deviation at the time of manufacturing such that the specific edge portion of reference marks 14a and 14b on the lower layer does not protrude from the specific edge portion recognized when the center coordinates of reference marks 14a and 14b are detected by the image processing. In other words, the size or the shape of reference marks 14a and 14b on each layer is changed such that the specific edge portion of reference marks 14a and 14b on the upper layer covers and hides the specific edge portion of reference marks 14a and 14b on the lower layer. Hereinafter, the method of forming reference marks 14a and 14b on each layer will be described using four examples.

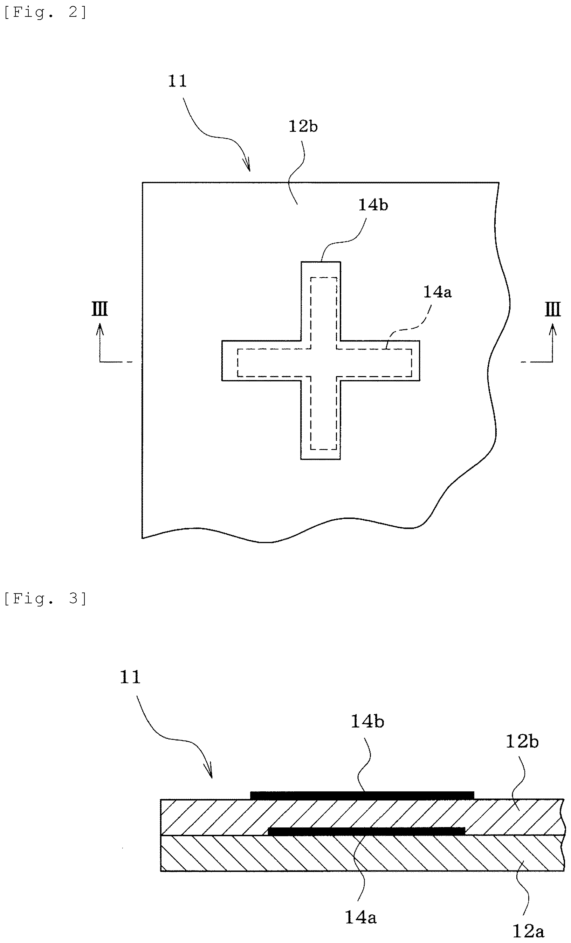

The first example, illustrated in Fig. 2 and Fig. 3, is an example in which the size of reference mark 14b on the upper layer is made larger than the size of reference mark 14a on the lower layer. In this example, reference marks 14a and 14b on each layer are formed in a cross shape, and the size of reference mark 14b on the upper layer is made larger than the size of reference mark 14a on the lower layer by equal to or more than the maximum amount of positional deviation at the time of manufacturing, and thus, even if there is a positional deviation of each layer, reference mark 14b on the upper layer is configured to cover and hide the entire reference mark 14a on the lower layer. As a result, the specific edge portion of reference mark 14a on the lower layer is configured not to protrude from the specific edge portion of reference mark 14b on the upper layer which is the target of image recognition.

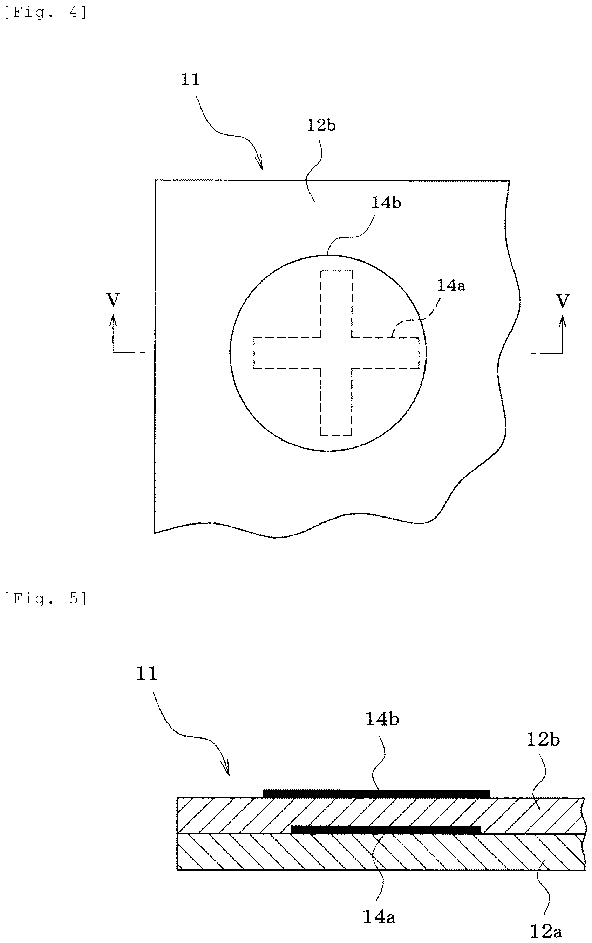

The second example, illustrated in Fig. 4 and Fig. 5, is an example in which the shape of reference mark 14b on the upper layer is changed from the shape of reference mark 14a on the lower layer. In this example, the shape of reference mark 14a on the lower layer is formed in a cross shape, and the shape of reference mark 14b on the upper layer is formed in a circle, a diameter of circle-shaped reference mark 14b on the upper layer is made larger than the vertical and horizontal length dimensions of cross-shaped reference mark 14a on the lower layer by equal to more than the maximum amount of positional deviation at the time of manufacturing, and thus, even if there is a positional deviation of each layer, circle-shaped reference mark 14b on the upper layer is configured to cover and hide the entire cross-shaped reference mark 14a on the lower layer. As a result, the specific edge portion of reference mark 14a on the lower layer is configured not to protrude from the specific edge portion of reference mark 14b on the upper layer which is the target of image recognition.

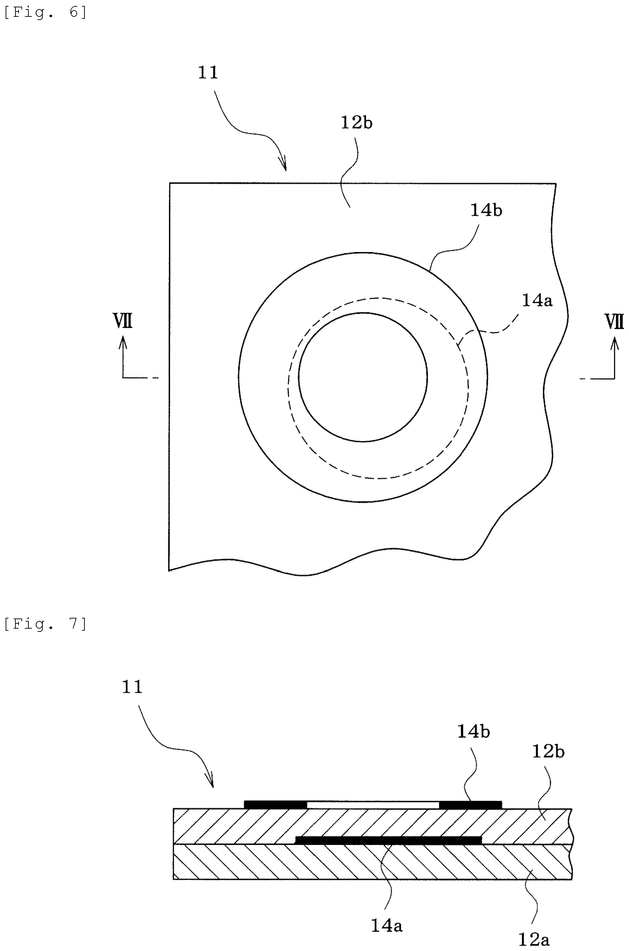

The third example, illustrated in Fig. 6 and Fig. 7, is an example in which the shape of reference mark 14b on the upper layer is changed such that the outer peripheral edge which is the specific edge portion of reference mark 14a on the lower layer is covered and hidden. In this example, the shape of reference mark 14a on the lower layer is formed in a circle shape, and the shape of reference mark 14b on the upper layer is formed in a ring shape, and by making a diameter of the outer circumference of ring-shaped reference mark 14b on the upper layer be larger than a diameter of circle-shaped reference mark 14a on the lower layer by equal to or more than the maximum amount of positional deviation at the time of manufacturing, and by making the diameter of the inner peripheral edge of ring-shaped reference mark 14b on the upper layer be smaller than a diameter of circle-shaped reference mark 14a on the lower layer by equal to or more than the maximum amount of positional deviation at the time of manufacturing, even if there is a positional deviation of each layer, ring-shaped reference mark 14b on the upper layer is configured to cover and hide the outer peripheral edge which is the specific edge portion of circle-shaped reference mark 14a on the lower layer. As a result, the specific edge portion (outer peripheral edge) of circle-shaped reference mark 14a on the lower layer is configured not to protrude from the specific edge portion (outer peripheral edge) of ring-shaped reference mark 14 on the upper layer which is the target of image recognition. In this configuration, a central side portion of circle-shaped reference mark 14a on the lower layer can be seen through the inner circumference side of ring-shaped reference mark 14b on the upper layer during the image recognition, and the inner peripheral edge of layer ring-shaped reference mark 14b on the upper layer cannot be distinguished and recognized from circle-shaped reference mark 14a on the lower layer, however, since the inner peripheral edge of the ring-shaped reference mark 14b is not a specific edge portion to be recognized when detecting the center coordinates of reference mark 14b, there will be no problem. The inner peripheral edge of reference mark 14b which is not a specific edge portion may not have a circle shape and may have any shape such as a square.

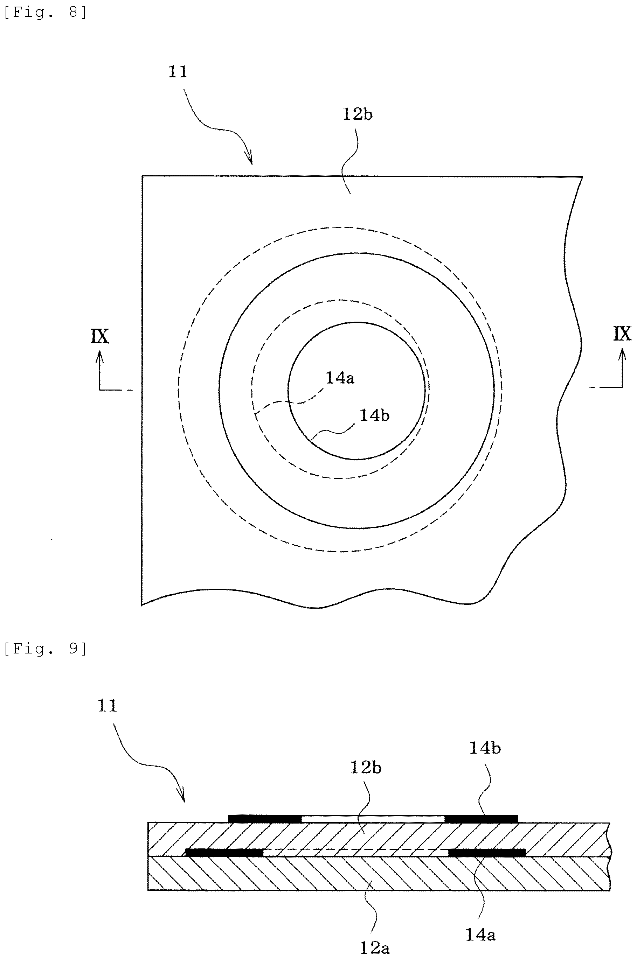

The fourth example, illustrated in Fig. 8 and Fig. 9, is an example in which the size of reference mark 14b on the upper layer is made smaller than the size of reference mark 14a on the lower layer. In this example, reference marks 14a and 14b on each layer are formed in a ring shape which is a hollow shape, and the edge portion (inner peripheral edge) inside reference marks 14a and 14b of this ring shape is used as the specific edge portion to be recognized when the center coordinates of reference marks 14a and 14b are detected. In this example, by making the diameter of the inner peripheral edge of reference mark 14b on the upper layer be smaller than the diameter of the inner peripheral edge of reference mark 14a on the lower layer by equal to or more than the maximum amount of positional deviation at the time of manufacturing, ring-shaped reference mark 14b on the upper layer covers and hides the inner peripheral edge which is the specific edge portion of reference mark 14a on the lower layer, and thus, even if there is a positional deviation of each layer, reference mark 14a on the lower layer protrudes from the inner circumference side of reference mark 14b on the upper layer so as not be seen through. In this case also, the outer peripheral edges of reference marks 14a and 14b which are not the specific edge portions, need not be a circle shape, and may have any shape such as a square shape.

There are various methods for manufacturing multilayer circuit substrate 11 configured as described above.

For example, there is a method of manufacturing multilayer circuit substrate 11 by repeating a step of forming wiring pattern 13a and reference mark 14a on the upper surface of insulating layer 12a in a predetermined positional relationship, a step of recognizing the specific edge portion of reference mark 14a by imaging reference mark 14a of insulating layer 12a from above with a camera and by processing the image and detecting the center coordinates of reference mark 14a, and a step of positioning and stacking insulating layer 12b to be stacked on insulating layer 12a with reference to the detected center coordinates of reference mark 14a. In this method, in the step of forming wiring pattern 13a and reference mark 14a on the upper surface of insulating layer 12a in a predetermined positional relationship, the size or shape of reference marks 14a and 14b on each layer may be changed and formed considering the maximum amount of positional deviation of reference mark 14a between the layers at the time of manufacturing such that specific edge portion of reference mark 14a on the lower layer does not protrude from the specific edge portion of reference mark 14b on the upper layer, in other words, such that the specific edge portion of reference mark 14b on the upper layer covers and hides the specific edge portion of reference mark 14a on the lower layer. Here, the maximum amount of positional deviation of reference marks 14a and 14b between the layers at the time of manufacturing may be set from, for example, the positioning performance of a manufacturing apparatus, or may be set from prototype data acquired in the process of making a prototype. In addition, first, the production manager may presume and temporarily set the maximum positional deviation amount of reference marks 14a and 14b, and then, the set value of the maximum positional deviation amount may be modified from time to time based on the production record data acquired in the subsequent production so as to reduce the failure occurrence rate.

In addition, for example, when a 3D printer having a configuration including a printing head of a resin ink and an ink for a metal circuit is used for one processing stage, the ink of the insulating material is discharged to form a first layer of insulating layer 12a, and the ink of the metal nanoparticles is discharged to the upper surface of the first layer of insulating layer 12a to form wiring pattern 13a and reference mark 14a in a predetermined positional relationship to form the first circuit layer, and thereafter, a step of recognizing the specific edge portion of reference mark 14a by imaging reference mark 14a on insulating layer 12a with a camera from above and processing the image while maintaining the position of the workpiece on the same stage as it is, and detecting the center coordinates of reference mark 14a is performed, and a step of positioning and forming insulating layer 12b stacked on insulating layer 12a and wiring pattern 13b of the metal nanoparticles to be printed on the surface thereof is performed with reference to the center coordinates of detected reference mark 14a. Multilayer circuit substrate 11 may be manufactured by repeating the step of forming reference mark 14b together with wiring pattern 13b in a predetermined positional relationship and forming the n-th (n = 2, 3, ...) circuit layer.

Alternatively, multilayer circuit substrate 11 may be manufactured by repeating a step of forming upper insulating layer 12b with the insulating material on lower insulating layer 12a on which wiring pattern 13a and reference mark 14a are formed in a predetermined positional relationship, with reference to the detected center coordinates of reference mark 14a, and a step of positioning and forming wiring pattern 13b and reference mark 14b on the upper surface of upper insulating layer 12b with reference to the center coordinates of reference mark 14a that can be seen through directly under lower insulating layer 12a.

As another method for manufacturing, after forming wiring patterns 13a and 13b and reference marks 14a and 14b on the upper surfaces of non-stacked multiple insulating layers 12a and 12b in a predetermined positional relationship, respectively, multilayer circuit substrate 11 may be manufactured by positioning and stacking insulating layers 12a and 12b of each layer with reference to the center coordinates of reference mark 14a on the lower layer.

According to the present embodiment described above, since each reference mark 14a and 14b is formed by changing the size or shape such that the specific edge portion of reference mark 14a on the lower layer does not protrude from the specific edge portion recognized when the center coordinates of reference mark 14b on the upper layer is detected by image processing considering the positional deviation of reference marks 14a and 14b on each layer at the time of manufacturing, it is possible to prevent reference mark 14a on the lower layer from protruding from the specific edge portion of reference mark 14b on the upper layer which is image-recognized as an image from above during stacking. As a result, the specific edge portion of reference mark 14b on the upper layer can be accurately image-recognized, and the center coordinates of reference mark 14b on the upper layer can be accurately detected from the position of the specific edge portion, and thus, it is possible to improve the positioning accuracy of each layer of multilayer circuit substrate 11 and improve the connection reliability between the layers.

The present invention is not limited to the above embodiment, and it is needless to say that various changes can be made without departing from the gist such as changing the positions on which reference marks 14a and 14b are formed on insulating layers 12a and 12b of each layer, changing the shapes of reference marks 14a and 14b, and changing the number of stacked insulating layers 12a and 12b, and the like.

### Reference Signs List

11 ... multilayer circuit substrate, 12a, 12b ... insulating layer, 13a, 13b ... wiring pattern, 14a, 14b ... reference mark

## Claims

1. A multilayer circuit substrate in which multiple insulating layers are stacked, wiring patterns and reference marks are formed on an upper surface of each insulating layer in a predetermined positional relationship, and the reference marks on the insulating layers are formed at an overlapping position when viewed from above, wherein the reference mark on each layer is formed by changing a size or a shape such that from a specific edge portion recognized when center coordinates of the reference mark is detected by image processing a specific edge portion of the reference mark on a lower layer of the specific edge portion does not protrude considering a positional deviation at the time of manufacturing.

2. The multilayer circuit substrate according to Claim 1,
wherein the multiple insulating layers are formed of an insulating material having light transparency or an insulating material designed to be extremely thin so that a lower layer can be seen through even if the light transparency is poor.

3. The multilayer circuit substrate according to Claim 1 or 2,
wherein the reference mark on each layer is formed in a shape that recognizes an outside edge portion as the specific edge portion when the center coordinates of the reference mark is detected by image processing, and is formed such that the size of the reference mark on an upper layer is larger than the size of the reference mark on the lower layer by equal to or more than a maximum amount of positional deviation at the time of manufacturing.

4. The multilayer circuit substrate according to Claim 1 or 2,
wherein the reference mark on each layer is formed in a hollow shape that recognizes an inside edge portion as the specific edge portion when the center coordinates of the reference mark is detected by image processing, and is formed such that the size of the reference mark on an upper layer is smaller than the size of the reference mark on the lower layer by equal to or more than a maximum amount of positional deviation at the time of manufacturing.

5. A method for manufacturing a multilayer circuit substrate by repeating a step of forming a wiring pattern and a reference mark on an upper surface of an insulating layer in a predetermined positional relationship, a step of recognizing a specific edge portion of the reference mark by imaging the reference mark on the insulating layer from above with a camera and processing the image to detect center coordinates of the reference mark, and a step of positioning and stacking an insulating layer to be stacked on the insulating layer with reference to the detected center coordinates of the reference mark,
wherein, in the step of forming the wiring pattern and the reference mark on the upper surface of the insulating layer in a predetermined positional relationship, a size or a shape of the reference mark on each layer is changed and formed such that a specific edge portion of the reference mark on a lower layer does not protrude from a specific edge portion of the reference mark on an upper layer considering a positional deviation of the reference mark.

6. The method for manufacturing the multilayer circuit substrate according to Claim 5,
wherein the multilayer circuit substrate is manufactured by repeating a step of forming an upper insulating layer with an insulating material on a lower insulating layer on which the wiring pattern and the reference mark are formed in a predetermined positional relationship with reference to the detected center coordinates of the reference mark, and positioning and forming the wiring pattern and the reference mark on the upper surface of the upper insulating layer with reference to the center coordinates of the reference mark that can be seen through directly under the lower insulating layer.

7. The method for manufacturing the multilayer circuit substrate according to Claim 5,
wherein the multilayer circuit substrate is manufactured by repeating a step of forming an upper insulating layer with an insulating material on a lower insulating layer on which the wiring pattern and the reference mark are formed in the predetermined positional relationship with reference to the detected center coordinates of the reference mark, and forming the wiring pattern and a new reference mark on the upper surface of the insulating layer while maintaining a position of a workpiece on the same stage.

8. The method for manufacturing the multilayer circuit substrate according to any one of Claims 5 to 7,
wherein the insulating layer, the wiring pattern and the reference mark on each layer are formed using a 3D printer.

9. The method for manufacturing the multilayer circuit substrate according to Claim 5,
wherein the multilayer circuit substrate is manufactured by repeating a step of positioning and stacking the insulating layer of each layer with reference to the center coordinates of the reference mark on the lower layer after forming the wiring pattern and the reference mark on upper surfaces of non-stacked multiple insulating layers in a predetermined positional relationship.
